# EUROPÄISCHE PATENTSCHRIFT

(11) **EP 1 392 088 B1**
(45) Veröffentlichungstag und Bekanntmachung des Hinweises auf die Patenterteilung: **13.01.2010**
(21) Anmeldenummer: 03008429.7
(22) Anmeldetag: 11.04.2003
(51) Int. Cl.: H05K 1/02, H05K 7/20

(54) **Elektronik-Einheit mit wärmeleitender Folie**
Electronic unit with a thermally conductive sheet
Unité électronique avec une feuille thermoconductrice

(30) Priorität: 17.08.2002 DE 10237716
(43) Veröffentlichungstag der Anmeldung: 25.02.2004
(73) Patentinhaber: ROBERT BOSCH GMBH, 70442 Stuttgart (DE)
(72) Erfinder: Speth, Michael, 77815 Buehl (DE); Walter, Gerd, 67410 Rohrwiller (FR)

(56) Entgegenhaltungen:
- US-A- 4 574 879
- US-A- 4 974 119
- US-A- 6 090 484
- PATENT ABSTRACTS OF JAPAN Bd. 2000, Nr. 02, 29. Februar 2000 (2000-02-29) & JP 11 330709 A (ISHIKAWAJIMA HARIMA HEAVY IND CO LTD), 30. November 1999 (1999-11-30)

## Beschreibung

### Stand der Technik

Die Erfindung betrifft eine Elektronikeinheit, insbesondere ein Steuergerät eines elektromotorischen Antriebs mit einer wärmeleitenden Folie nach der Gattung des unabhängigen Anspruchs 1.

Mit der JP 11330709 ist eine Vorrichtung bekannt geworden, bei der ein Substrat mittels eines Verbindungselements mit einer Metallplatte verbunden wird, die als Wärmesenke dient. Dabei ist zwischen dem Substrat und der Metallplatte eine dünne Schicht angeordnet, die eine Aussparung für die Aufnahme einer metallenen Unterlegscheibe aufweist, die die Funktion eines Abstandshalters aufweist.

Mit der US 6,090,484 ist eine bewegliche Wärmeleitfolie bekannt geworden, die zwischen Elektronikbauteilen und einer Wärmesenke angeordnet ist, um die Wärme schnell von den Elektronikbauteilen abzuführen. Die Wärmeleitfolie besteht hierbei aus mehreren Schichten, beispielsweise thermisch leitfähige Polymer-Lagen, die auf einem flexiblen Film als Substrat aufgebracht sind.

Werden solche Folien eingesetzt, um die Abwärme von Leiterplatten abzuführen, welche in geeigneter Weise an Wärmesenken - wie beispielweise Gehäuseteilen oder Kühlwinkel aus Aluminium - mittels Verbindungsmittel befestigt werden, so verformt sich sowohl die flexible wärmeleitende Folie, als auch die Leiterplatte insbesondere im Bereich der Verbindungselemente. Mit zunehmender Anforderungen an die Schwingungsbelastung steigt die von den Verbindungselementen aufzubringende Klemmkraft, so dass die Deformation der Leiterplatte zunimmt. Solche Materialspannungen führen teilweise zu Schäden an den elektronischen Bauelementen, wie beispielsweise multilayer ceramic capacitors (MLCC), bzw. führen dazu, dass im Bereich der Verbindungselemente keine empfindlichen Bauelemente auf der Leiterplatte angeordnet werden können, was wiederum zu Bauraumproblemen führt.

### Vorteile der Erfindung

Die erfindungsgemäße Vorrichtung mit den Merkmalen des Anspruchs 1 hat den Vorteil, dass aufgrund der Anordnung eines Versteifungselements die wärmeleitende Folie bei deren Befestigung auf der Leiterplatte nur noch begrenzt deformiert wird. Die Versteifungen um die Verbindungselemente führen dazu, dass insbesondere im Befestigungsbereich der Wärmeleitfolie eine geringere, gleichmäßigere Flächenpressung zwischen der Wärmesenke, der Wärmeleitfolie und der Leiterplatte erzeugt wird. Dadurch wird die Leiterplatte deutlich geringer deformiert, so dass auch empfindliche Bauteile, wie Keramik-Kondensatoren, in unmittelbarer Nähe zu den Verbindungselementen auf der Leiterplatte fixiert werden können. Bei mehreren notwendigen Verbindungselementen kann insbesondere für Anwendungen im Kraftfahrzeugbereich der Bauraum der Steuergeräte deutlich reduziert werden und eine Beschädigung der elektronischen Bauelemente durch mechanische Spannungen der Leiterplatte vermieden werden.

Die Wärmeleitfolie besteht aus mehreren zusammengesetzten Schichten, wobei sich zumindest eine Schicht radial über das Versteifungselement erstreckt, um eine einfache Fixierung desselben an der Wärmeleitfolie zu ermöglichen. Dies erhöht sowohl die mechanische Stabilität, als auch die Flexibilität im Befestigungsbereich der Wärmeleitfolie und erlaubt eine exakte Justage des Versteifungsmittels.

Durch die in den Unteransprüchen aufgeführten Merkmale sind vorteilhafte Weiterbildungen der Vorrichtung nach dem Anspruch 1 möglich.

In vorteilhafter Weise sind die Versteifungselemente derart ausgeführt, dass sie bei montierten Verbindungselementen die Spannkräfte zwischen der Wärmesenke und der Leiterplatte aufnehmen. Dies führt zu einem verbesserten, geringeren Setzverhalten der Wärmeleitfolie im Bereich der Verbindungselemente. Dadurch wird ein guter thermischer Kontakt erzielt, ohne dass sich dabei die Leiterplatte verbiegt. Die gute thermische Kontakt der Leiterplatte zu einer Kühlfläche bewirkt dabei eine effiziente Wärmeabfuhr von den auf der Leiterplatte angeordneten Bauteile.

Günstig ist es, die Versteifungselemente als Aufnahmen der Verbindungselemente in Aussparungen der Wärmeleitfolie zu befestigen. Dadurch ist gewährleistet, dass die Verbindungselemente nicht beliebig stark auf die Wärmeleitfolie drücken. Die Aussparungen erstrecken sich beispielsweise nicht über die gesamte Dicke der Wärmeleitfolie, so dass die Versteifungselemente beispielsweise auf einem Trägermaterial mit relativ geringer Kompressibilität befestigt werden können. Dies ermöglicht eine kompakte Bauweise der Wärmeleitfolie bei Erhalt der notwendigen mechanischen Flexibilität der Wärmeleitfolie für deren thermischen Kontakt.

Ist das Versteifungselement als Ring oder Hülse ausgeformt, die von der Aussparung in der Wärmeleitfolie aufgenommen werden, so ist es von Vorteil, wenn der Außendurchmesser des Versteifungselements gleich groß oder größer ist als die maximale Ausdehnung des Kopfes eines Verbindungselements. Dadurch ist gewährleistet, dass die gesamte Anpresskraft des Verbindungselements direkt auf das Versteifungselement übertragen wird. Dadurch können auch höhere Vorspannkräfte aufgebracht werden, die auch ein Lösen der Verbindung bei starker Vibration verhindern. Durch das Anbringen mehrerer Versteifungselemente mit korrespondierenden Verbindungselementen kann eine steifere Einspannung der Leiterplatte realisiert werden, woraus eine schwingungsärmere Befestigung der Leiterplatte oder der Bauelemente resultiert.

Das Versteifungselement besteht aus einem Material, das sich unter der Belastung des Anzugmoments der Verbindungsmittel nicht nennenswert verformt, wodurch ein sogenannter harter Schraubfall realisiert werden kann. Aufgrund der definierten Endlage des Kopfes der Verbindungsmittel durch eine geringe Streuung der Deformation der Folie, sowie der besseren Positionierung des Versteifungselements innerhalb der Aussparung der Wärmeleitfolie können Schraubfehler bei der Montage reduziert werden. Die geringere Deformation der Folie ermöglicht einen definierteren Anzug und Überwachung der Verschraubung.

Durch die Verwendung eines solch harten Materials für das Versteifungselement können bestimmte Bereiche desselben derart geformt werden, dass sie einen axialen Anschlag für das Verbindungselement bilden, wodurch eine weitere Kompression der Wärmeleitfolie verhindert wird.

In verschiedenen Ausführungsbeispielen ist das Versteifungselement in die Wärmeleitfolie eingeklebt, eingespritzt, eingepresst, eingeschweißt oder als Clips-Verbindung ausgeführt. All diese Verbindungstechniken gewährleisten eine sichere Fixierung des Versteifungselements innerhalb der Wärmeleitfolie, wobei diese Verfahren herstellungstechnisch sicher und einfach zu handhaben sind.

Besonders einfach und sicher lassen sich die Bauelemente und/oder die Leiterplatte mit Schrauben, Nieten oder Klammern auf einer Leiterplatte befestigen, da deren Kopf eine relativ große Fläche für die Kraftübertragung auf das Versteifungselement der Wärmeleitfolie aufweisen.

Die Wärmeleitfolie stellt eine gute thermische Brücke zwischen den elektronischen Bauelementen und einer Wärmesenke dar, die beispielsweise bei einer Steuerelektronik als metallische Außenfläche des Gehäuses, insbesondere als Aluminiumguss-Teil, ausgebildet sein kann. Dadurch ist es möglich, die Steuerelektronik beispielsweise auch in unmittelbarer Nähe eines sich stark erwärmenden Motors anzuordnen, was teilweise durch die hohen Anforderungen an die elektromagnetische Verträglichkeit der Elektronik-Einheit notwendig ist.

Besonders effizient ist die Anwendung der erfindungsgemäßen Vorrichtung bei der Verwendung von Leistungstransistoren, Leistungsendstufen oder Dioden als Bauteile, die große Wärmemengen generieren. Befinden sich unmittelbar in deren Nähe ebenfalls keramische Dünnfilmbauelemente, wie beispielsweise gegenüber mechanischen Spannungen empfindlichen MLCCs, können diese mittels der Versteifungselemente in der Wärmeleitfolie vor einer Zerstörung geschützt werden.

Bei der Montage der Folie wird diese mittels Unterdruckdüsen vom Trägermaterial abgezogen und auf der Kühlfläche positioniert. Aufgrund der Flexibilität der Folie führt die undefinierte Greifposition der Unterdruckdüsen und die undefinierte Lage der Folie auf dem Träger zu großen Ungenauigkeiten bei der Positionierung der Folie. Da die Versteifungselemente in sich fest sind und mit geringen Toleranzen behaftet sind, können diese beispielsweise in Verbindung mit geeigneten Hilfsmittel (z.B. Dorn) zur exakten Positionierung auf der Leiterplatte oder der Kühlfläche verwendet werden. Hierdurch reduzieren sich die toleranzbedingt notwendigen Freiräume.

### Zeichnung

In der Zeichnung sind Ausführungsbeispiele einer erfindungsgemäßen Vorrichtung dargestellt und in der nachfolgenden Beschreibung näher erläutert.

Es zeigen:
Fig. 1: Ein Ausführungsbeispiel mittels eines Verbindungselements befestigter Bauelemente mit einer Leiterplatte einer Elektronik-Einheit im Schnitt,
Fig. 2 eine vergrößerte Darstellung zweier Varianten eines Versteifungselements im Schnitt gemäß Fig. 1,
Fig. 3 eine Draufsicht auf das Versteifungselement in Fig. 2 und
Fig. 4 zweit weitere Varianten eines Versteifungselements im Schnitt.

### Beschreibung

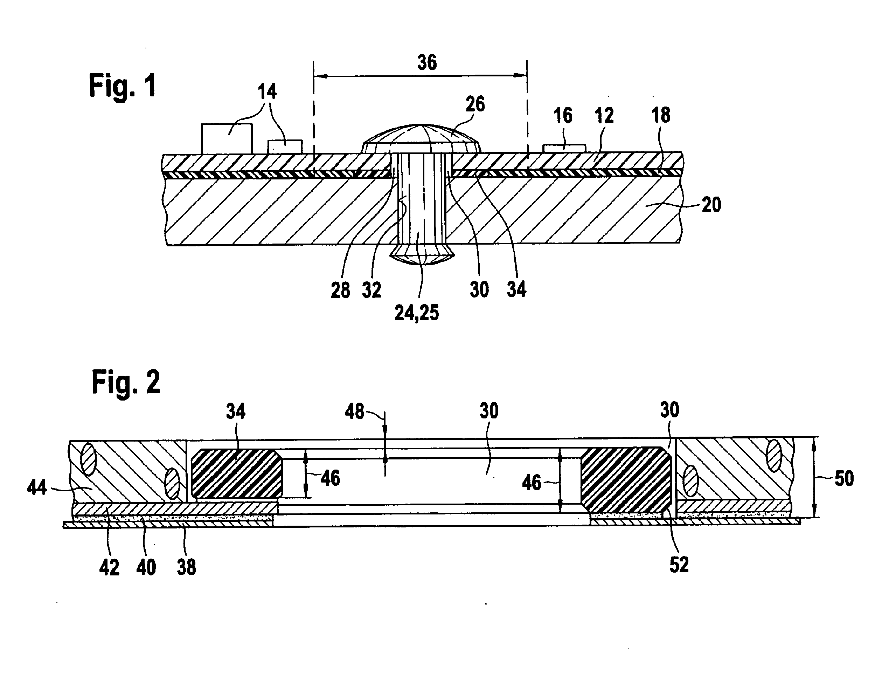

Das in Fig. 1 dargestellte Ausführungsbeispiel zeigt einen Ausschnitt einer erfindungsgemäßen Elektronikeinheit 10, bei der auf einer Leiterplatte 12 Bauelemente 14 angeordnet sind, die im Betriebszustand Wärme erzeugen. Dies sind beispielsweise Dioden, eine Leistungsendstufe oder Transistoren zur Ansteuerung einer nicht näher dargestellten, elektrischen Antriebseinheit. Auf der Leiterplatte 12 befinden sich des weiteren Dünnfilmbauelemente 16, wie beispielsweise keramischen Chip-Bauteilen (MLCC), die sehr empfindlich sind gegenüber einer mechanischen Verbiegung der Leiterplatte 12. Zur besseren Ableitung der durch die Bauteile 14 generierte Wärme, ist die Leitplatte 12 über eine wärmeleitende Folie 18 mit einer Kühlfläche 20 verbunden. Die Kühlfläche 20 ist im Ausführungsbeispiel 1 als Kühlkörper innerhalb eines nicht dargestellten Gehäuses ausgebildet, kann aber ebenfalls als Teil einer Gehäusewand 21 ausgebildet sein. In Fig. 1 ist als Verbindungsmittel 24 zwischen der Leiterplatte 12 und der Kühlfläche 20 eine Niet 25 dargestellt, die durch ein Loch 28 in der Leiterplatte 12, durch eine Aussparung 30 der Folie 18 und eine Bohrung 32 in der Kühlfläche 20 greift. Bei der Montage wird die Leiterplatte 12 durch den Kopf 26 des Verbindungsmittels 24 gegen die Kühlfläche 20 gepresst, wobei die kompressible Wärmeleitfolie 18 so weit zusammengedrückt wird, bis durch die Spannkraft des Verbindungsmittels 24 sowohl die Leiterplatte 12 als auch die Kühlfläche 20 an einem Versteifungselement 34 anliegen, das an der Wärmeleitfolie 18 angeordnet ist. Durch solch eine definierte Kompression der Wärmeleitfolie 18 ist zum einen gewährleistet, dass eine optimale Flächenpressung zwischen Wärmeleitfolie 18 und der Kühlfläche 20 sowie der Leiterplatte 12 für einen optimalen Wärmetransport gewährleistet ist, andererseits wird durch das Versteifungselement 34 verhindert, dass der Kopf 26 des Verbindungsmittels 24 die Leitplatte 12 zu stark verbiegt. In unmittelbarer Nähe der Verbindungselemente 24 sind sogenannte Sperrzonen 36 definiert, innerhalb derer die mechanische Verspannung der Leiterplatte 12 so stark ist, dass empfindliche keramische Dünnfilmbauelemente 16 durch eine solche Verformung der Leiterplatte 12 beschädigt werden könnten. Durch die Verwendung der erfmdungsgemäßen Versteifungselemente 34 kann die Ausdehnung diese Sperrzonen 36 deutlich reduziert werden, so dass mehr Bauraum für empfindliche elektronische Bauelemente 16 zur Verfügung steht.

Fig. 2 zeigt einen vergrößerten Querschnitt durch die wärmeleitende Folie 18 mit 2 Varianten eines Versteifungselements 34. Die Wärmeleitfolie 18 wird auf einem Träger 38 als Rollenmaterial angeliefert. Auf dem Träger 38 ist mittels einer komprimierbaren Klebstoffschicht 40 eine elektrische Isolierschicht 42, beispielsweise ein faserverstärkter Kunststoff mit geringem Wärmeausdehnungs-Koeffizienten (Polymide film), gefolgt von einer Schicht 44 guter thermischer Leitung, wie beispielweise ein Faserträger mit einem Aluminiumoxyd- oder Bohrnitrit- Silicon-Gemisch. Um nun ein ringförmiges Versteifungselement 34 an der Wärmeleitfolie 18 anzuordnen, wird in diese zuerst eine Aussparung 30 ausgestanzt. Diese Aussparung 30 erstreckt sich in der Variante auf der rechten Seite der Fig. 2 bis auf den Träger 38, so dass nach dem Entfernen des ausgestanzten Materials das Verfestigungselement 34 direkt auf den Träger 38 geklebt wird. In der linken Bildhälfte erstreckt sich die Aussparung 30 nur bis zur Isolierschicht 42, so dass hier das Versteifungselement 34 direkt auf die Isolierschicht 42 der Wärmeleitfolie 18 aufgeklebt wird. Die axiale Materialstärke 46 des Versteifungselements 34 ist um den Betrag 48 geringer als die Gesamtdicke 50 der Wärmeleitfolie 18 in unmontiertem Zustand, die typischerweise in etwa 0,2 mm beträgt. Der Betrag 48 entspricht dabei der angestrebten definierten Kompression der Wärmeleitfolie 18 und kann sich auch auf beiden axialen Seiten der Wärmeleitfolie 18 erstrecken.

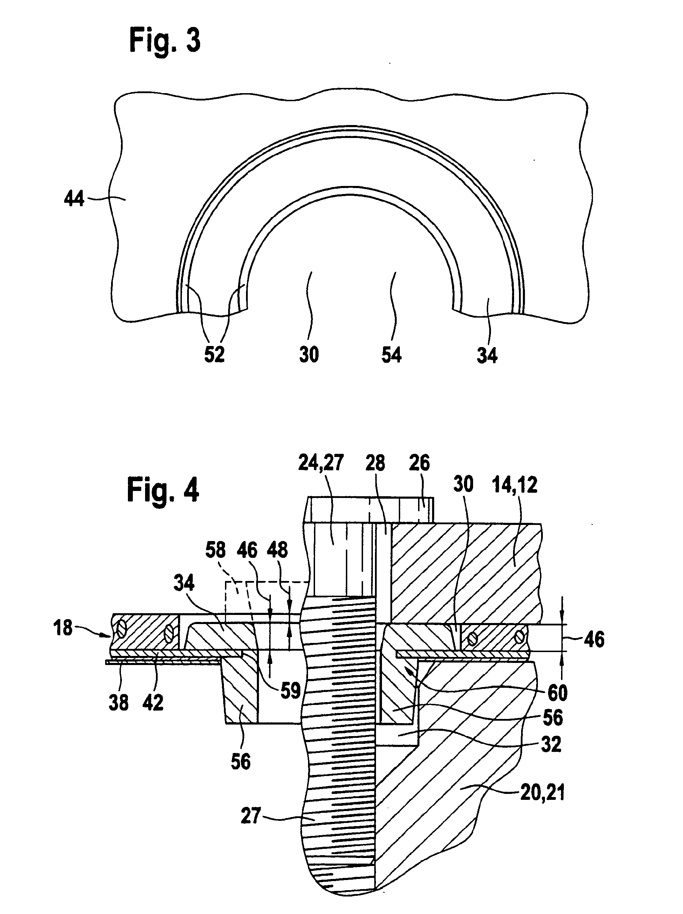

In Fig. 3 ist eine Draufsicht auf das Versteifungselement 34 aus Fig. 2 dargestellt. Aus der Wärmeleitschicht 44 ist die kreisförmige Aussparung 30 ausgestanzt, in die dann das Versteifungselement 34 eingefügt ist. Zur besseren Montage sind Phasen 52 angeformt. Bei der Montage der Folie 18 nimmt das ringförmige Versteifungselement 34 in seinem Inneren 54 ein Verbindungselement 24 auf, das sich durch das Loch 28, die Aussparung 30 und die Bohrung 32 erstreckt.

Fig. 4 zeigt zwei weitere Ausführungsbeispiele eines Versteifungselements 34, wobei links ein unmontierter, und rechts ein montierter Zustand dargestellt ist. Zur Zentrierung der Folie 18 gegenüber der Kühlfläche 20 weist das Versteifungselement 34 einen axialen Fortsatz 56 auf, der in die Bohrung 32 der Kühlfläche 20 eingreift. Die Kühlfläche 20 ist in diesem Ausführungsbeispiel als Teil einer Gehäusewand 21 ausgebildet, die vorzugsweise aus Metall gefertigt ist. Das Versteifungselement 34 ist hier ebenfalls innerhalb einer Aussparung 30 der Wärmeleitfolie 18 angeordnet, jedoch formschlüssig mit einem Kragen 59 der Isolierschicht 42 verbunden. Dies ist im Ausführungsbeispiel in Form einer Clips-Verbindung 60 realisiert. Das Versteifungselement 34 kann aber ebenso mit einzelnen oder mehreren Schichten der Wärmeleitfolie verschweißt, eingepresst oder eingespritzt sein. Die Kühlfläche 20 steht hier über die Wärmeleitfolie 18 direkt in thermischem Kontakt mit den wärmeerzeugenden Bauteilen 14, beispielsweise einem MOSTET, oder einer Leiterplatte 12, die mittels einer Schraube 27 als Verbindungselement 24 an der Kühlfläche 20 festgeschraubt sind. Dabei presst der Kopf 26 des Verbindungselements 24 das Bauteil 14 gegen die Kühlfläche 20, wodurch die Wärmeleitfolie 18 um den definierten Betrag 48 komprimiert wird, bis das Bauteil 14 an dem Versteifungselement 34 anliegt. Das Versteifungselement 34 ermöglicht eine definierte Anpresskraft durch das Verbindungselement 24, wodurch übermäßige mechanische Spannungen im Bauteil 14 vermieden werden. Der Außendurchmesser des Versteifungselements 34 ist in diesem Ausführungsbeispiel größer als der Durchmesser des Kopfes 26 des Verbindungselements 24, wodurch die gesamte Anpresskraft von dem Versteifungselement 34 aufgenommen wird. Die hohe Steifigkeit des Versteifungselements 34 ermöglicht daher einen harten Schraubfall, der Voraussetzung für eine steifere Einspannung der Leiterplatte 12 oder der Bauelemente 14 ist.

Auf der linken Seite der Fig. 4 ist eine weitere Variante eines Versteifungselements 24 in unmontiertem Zustand dargestellt. Zusätzlich zum axialen Fortsatz 56 zur Zentrierung der Folie 18 gegenüber der Kühlfläche 20 ist hier ein weiterer axialer Fortsatz 58 angeformt, der in ein Loch 28 der Leiterplatte 12 oder eines Bauteils 14 greift, um diese zusätzlich gegenüber der Wärmeleitfolie 18 zu zentrieren. Dadurch werden die Bauteile 14 und/oder die Leiterplatte 12 exakt gegenüber der Kühlfläche 20 positioniert. Auch bei diesem Ausführungsbeispiel weist das Versteifungselement 34 ein-Bereich-mit-einer vorgegebenen axialen Materialstärke 46 auf, der den Betrag 48 der Kompression der Wärmeleitfolie 18 definiert.

In einer Variation sind die Fortsätze 56 und 58 als Dome ausgebildet, deren freie Enden abgeplättet werden können, so dass das Versteifungselement 34 gleichzeitig die Funktion eines nietenähnlichen Verbindungsmittels 24, 25 übernimmt. Alternativ ist an den Domen eine Clips-Element angeformt, die in entsprechende Gegenelemente in der Kühlfläche 20, 21 oder am Bauelement 14 greifen. In einer weiteren Ausgestaltung sind die Versteifungselemente 34 mit integrierten Verbindungsmittel 24 als Dome 56, 58 am Gehäuse 21 angeformt, um die Bauteile 14 über die Folie 18 am Gehäuse zu befestigen.

Das Versteifungselement 34 ist im Ausführungsbeispiel aus Kunststoff gefertigt, der deutlich härter ist als das Material der Folie 18. Solche Versteifungselemente können für eine Vielzahl verschiedener Wärmeleitfolien eingesetzt werden und sind nicht auf bestimmte Materialien oder Strukturen beschränkt. Die Anzahl und konkrete Ausführung der Versteifungselemente 34 mit den korrespondierenden Verbindungselementen 24 ist der jeweiligen Anwendung angepasst, so dass beispielsweise mittels Anordnung mehrerer Verbindungselemente Schwingungen bei hoher Vibrationsbelastung unterbunden werden können.

Bei Anwendungen mit hoher Schüttelbeanspruchung ist es besonders wichtig, dass die Leiterplatte 12 zuverlässig gegenüber dem Gehäuse 21 isoliert ist. Hierbei treten die elektrisch isolierenden Eigenschaften der Folie 18 gegenüber deren Wärmeleitungsfunktion in den Vordergrund. Eine solche Anwendung als Isolierfolie 18 ist auch für Leiterplatten 12 und Bauelemente 14 denkbar, deren Wärmeproduktion vernachlässigbar ist.

In einer weiteren Variation des Ausführungsbeispiels ist das Versteifungselement 34 zwei- oder mehrteilig ausgebildet, wobei zwischen den beiden Teilen eine oder mehrere Lagen der Folie 18 aufgenommen und beispielsweise mit diesen verklebt oder eingeclipst werden.

Die Erfindung umfasst auch einzelne Merkmale der Ausführungsbeispiele oder eine beliebige Kombination der Merkmale der unterschiedlichen Ausführungsbeispiele. Eine bevorzugte Anwendung der erfindungsgemäßen Elektronikeinheit ist ein zentrales oder dezentrales Steuergerät für ein automatisches Schaltgetriebe, insbesondere für den Kupplungssteller.

## Patentansprüche

1. Elektronik-Einheit (10) - insbesondere ein Steuergerät eines elektromotorischen Antriebs - mit mindestens einem wärmegenerierenden Bauteil (14), das mittels mindestens eines Verbindungselements (24, 25, 27) über eine wärmeleitende Folie (18) mit einer Kühlfläche (20, 21) verbunden ist, wobei die Folie (18) mindestens ein Versteifungselement (34) aufweist, das mit dem Verbindungselement (24, 25, 27) zusammenwirkt, **dadurch gekennzeichnet, dass** die Folie (18) kompressibel ist und aus mehreren Lagen (38, 40, 42, 44) besteht und mindestens eine Lage (38, 40, 42, 44) mit dem Versteifungselement (34) radial überlappt.

2. Elektronik-Einheit (10) nach Anspruch 1, **dadurch gekennzeichnet, dass** das mindestens eine Wärme generierende Bauteil (14) auf einer Leiterplatte (12) angeordnet ist, die sich über die Folie (18) im thermischen Kontakt mit der Kühlfläche (20) - insbesondere einem Gehäuseteil (21) - befindet.

3. Elektronik-Einheit (10) nach einem der Ansprüche 1 oder 2, **dadurch gekennzeichnet, dass** das mindestens eine Versteifungselement (34) innerhalb einer Aussparung (30) der Folie (18) angeordnet ist.

4. Elektronik-Einheit (10) nach einem der Ansprüche 1 bis 3, **dadurch gekennzeichnet, dass** das mindestens eine Versteifungselement (34) ringförmig ausgebildet ist , und das mindestens einen Verbindungselement (24) aufnimmt.

5. Elektronik-Einheit (10) nach einem der Ansprüche 1 bis 4, **dadurch gekennzeichnet, dass** das mindestens eine Versteifungselement (34) eine größere Härte aufweist, als die Folie (18).

6. Elektronik-Einheit (10) nach einem der Ansprüche 1 bis 5, **dadurch gekennzeichnet, dass** über eine axiale Materialstärke (46) des Versteifungselements (34) der Anpressdruck der Folie (18) durch das mindestens eine Verbindungselement (24) definiert vorgebbar ist.

7. Elektronik-Einheit (10) nach einem der Ansprüche 1 bis 6, **dadurch gekennzeichnet, dass** das Versteifungselement (34) aus Kunststoff gefertigt ist.

8. Elektronik-Einheit (10) nach einem der Ansprüche 1 bis 7, **dadurch gekennzeichnet, dass** das mindestens eine Versteifungselement (34) mittels Kleben oder Einspritzen oder Pressen oder Schweißen oder einer Clips-Verbindung (60) mit der Folie (18) verbunden ist.

9. Elektronik-Einheit (10) nach einem der Ansprüche 1 bis 8, **dadurch gekennzeichnet, dass** die Verbindungselemente (24) als Schrauben (27) oder Nieten (25) oder Klammern oder Clips-Elemente oder verstemmbar angeformte Dome ausgeführt sind.

10. Elektronik-Einheit (10) nach einem der Ansprüche 1 bis 9, **dadurch gekennzeichnet, dass** die Elektronik-Einheit (10) keramische Dünnfilmbauelemente (16) - insbesondere MLCC-Kondensatoren - aufweist, und das mindestens eine Wärme generierende Bauteil (14) ein Transistor und/oder eine Leistungsendstufe und/oder eine Diode ist.

11. Elektronik-Einheit (10) nach einem der Ansprüche 1 bis 10, **dadurch gekennzeichnet, dass** das mindestens eine Versteifungselement (34) zugleich als Verbindungselement (24) , insbesondere als Clips-Verbindung zwischen der Leiterplatte (12) und der Kühlfläche (20, 21), ausgeführt ist.

12. Elektronik-Einheit (10) nach einem der Ansprüche 1 bis 11, **dadurch gekennzeichnet, dass** die Folie (18) elektrisch isolierend ausgebildet ist.

## Claims

1. Electronics unit (10) - in particular a controller of an electromotive drive - having at least one heat-generating component (14) which is connected to a cooling area (20, 21) by means of at least one connection element (24, 25, 27) via a thermally conductive foil (18), with the foil (18) having at least one reinforcing element (34) which interacts with the connection element (24, 25, 27), **characterized in that** the foil (18) is compressible and comprises a plurality of layers (38, 40, 42, 44) and radially overlaps at least one layer (38, 40, 42, 44) by way of the reinforcing element (34).

2. Electronics unit (10) according to Claim 1, **characterized in that** the at least one heat-generating component (14) is arranged on a printed circuit board (12) which is in thermal contact with the cooling area (20) - in particular a housing part (21) - via the foil (18).

3. Electronics unit (10) according to either of Claims 1 and 2, **characterized in that** the at least one reinforcing element (34) is arranged within a cutout (30) in the foil (18).

4. Electronics unit (10) according to one of Claims 1 to 3, **characterized in that** the at least one reinforcing element (34) is of annular design and accommodates the at least one connection element (24).

5. Electronics unit (10) according to one of Claims 1 to 4, **characterized in that** the at least one reinforcing element (34) has a greater degree of hardness than the foil (18).

6. Electronics unit (10) according to one of Claims 1 to 5, **characterized in that** the contact pressure of the foil (18) can be prespecified by means of an axial material thickness (46) of the reinforcing element (34), in a manner defined by the at least one connection element (24).

7. Electronics unit (10) according to one of Claims 1 to 6, **characterized in that** the reinforcing element (34) is produced from plastic.

8. Electronics unit (10) according to one of Claims 1 to 7, **characterized in that** the at least one reinforcing element (34) is connected to the foil (18) by means of adhesive bonding or injection moulding or compression or welding or a clip connection (60).

9. Electronics unit (10) according to one of Claims 1 to 8, **characterized in that** the connection elements (24) are designed in the form of screws (27) or rivets (25) or clamps or clip elements or domes which are integrally formed in a caulkable manner.

10. Electronics unit (10) according to one of Claims 1 to 9, **characterized in that** the electronics unit (10) has ceramic thin-film components (16) - in particular MLCC capacitors -, and the at least one heat-generating component (14) is a transistor and/or a power output stage and/or a diode.

11. Electronics unit (10) according to one of Claims 1 to 10, **characterized in that** the at least one reinforcing element (34) is simultaneously designed as a connection element (24), in particular as a clip connection between the printed circuit board (12) and the cooling area (20, 21).

12. Electronics unit (10) according to one of Claims 1 to 11, **characterized in that** the foil (18) is of electrically insulating design.

## Revendications

1. Unité électronique (10), notamment appareil de commande d'un entraînement par moteur électrique, comprenant au moins un composant générant de la chaleur (14), qui est connecté au moyen d'au moins un élément de connexion (24, 25, 27) par le biais d'une feuille thermoconductrice (18) à une surface de refroidissement (20, 21), la feuille (18) présentant au moins un élément de renforcement (34) qui coopère avec l'élément de connexion (24, 25, 27), **caractérisée en ce que** la feuille (18) est compressible et se compose de plusieurs couches (38, 40, 42, 44) et au moins une couche (38, 40, 42, 44) est superposée radialement à l'élément de renforcement (34).

2. Unité électronique (10) selon la revendication 1, **caractérisée en ce que** l'au moins un composant générant de la chaleur (14) est disposé sur une carte de circuits imprimés (12) qui se trouve en contact thermique avec la surface de refroidissement (20), notamment une partie de boîtier (21), par le biais de la feuille (18).

3. Unité électronique (10) selon l'une quelconque des revendications 1 ou 2, **caractérisée en ce que** l'au moins un élément de renforcement (34) est disposé à l'intérieur d'un évidement (30) de la feuille (18).

4. Unité électronique (10) selon l'une quelconque des revendications 1 à 3, **caractérisée en ce que** l'au moins un élément de renforcement (34) est réalisé sous forme annulaire, et reçoit l'au moins un élément de connexion (24).

5. Unité électronique (10) selon l'une quelconque des revendications 1 à 4, **caractérisée en ce que** l'au moins un élément de renforcement (34) présente une plus grande dureté que la feuille (18).

6. Unité électronique (10) selon l'une quelconque des revendications 1 à 5, **caractérisée en ce que** la pression d'application de la feuille (18) à travers l'au moins un élément de connexion (24) peut être prédéfinie de manière spécifique par le biais d'une épaisseur de matériau axiale (46) de l'élément de renforcement (34).

7. Unité électronique (10) selon l'une quelconque des revendications 1 à 6, **caractérisée en ce que** l'élément de renforcement (34) est fabriqué en plastique.

8. Unité électronique (10) selon l'une quelconque des revendications 1 à 7, **caractérisée en ce que** l'au moins un élément de renforcement (34) est connecté à la feuille (18) au moyen d'un collage ou d'une injection ou d'un pressage ou d'un soudage ou d'une connexion par enclipsage (60).

9. Unité électronique (10) selon l'une quelconque des revendications 1 à 8, **caractérisée en ce que** les éléments de connexion (24) sont réalisés sous forme de vis (27) ou de rivets (25) ou de pinces ou d'éléments d'enclipsage ou de dômes formés de manière rabattable.

10. Unité électronique (10) selon l'une quelconque des revendications 1 à 9, **caractérisée en ce que** l'unité électronique (10) présente des éléments constructifs en film mince en céramique (16), notamment des condensateurs MLCC, et l'au moins un composant générant de la chaleur (14) est un transistor et/ou un étage final de puissance et/ou une diode.

11. Unité électronique (10) selon l'une quelconque des revendications 1 à 10, **caractérisée en ce que** l'au moins un élément de renforcement (34) est réalisé en même temps comme élément de connexion (24), notamment sous forme de connexion par enclipsage entre la carte de circuits imprimés (12) et la surface de refroidissement (20, 21).

12. Unité électronique (10) selon l'une quelconque des revendications 1 à 11, **caractérisée en ce que** la feuille (18) est réalisée sous forme électriquement isolante.
